# EUROPEAN PATENT SPECIFICATION

(11) **EP 4 258 327 B1**
(45) Date of publication and mention of the grant of the patent: **12.03.2025**
(21) Application number: 22166851.0
(22) Date of filing: 05.04.2022
(51) Int. Cl.: H01L 21/67

(54) **AN APPARATUS FOR TRANSFERRING SEMICONDUCTOR CIRCUITS**
VORRICHTUNG ZUR ÜBERTRAGUNG VON HALBLEITERSCHALTUNGEN
APPAREIL DE TRANSFERT DE CIRCUITS SEMI-CONDUCTEURS

(43) Date of publication of application: 11.10.2023
(73) Proprietor: Nexperia B.V., 6534 AB Nijmegen (NL)
(72) Inventor: Huybers, Ralph, 6534 AB Nijmegen (NL)
(74) Representative: Pjanovic, Ilija

(56) References cited:
- WO-A1-03/058708
- US-A1- 2014 212 246
- US-A1- 2019 122 917

## Description

Semiconductor circuits are manufactured on and in a circular plane substrate, also referred to as a wafer, in a matrix having a plurality of rows and columns of such circuits. Although not a strict requirement, such circuits usually are all identical and all have the same dimensions. After the wafer production, a surface of the wafer is adhered to a flexible carrier film. The respective circuits are then physically separated from each other by cutting through the wafer from one surface to the opposite surface without cutting through the carrier film. Thus, a plurality of individual semiconductor circuits (hereinafter also to be referred to as "chips" or "dies") arranged on the carrier film is obtained.

In an known example, an apparatus for transferring chips from a first position, e.g. in which position the wafer with the matrix of semiconductor circuits is positioned, to at least a second position, e.g. in which position a carrier film with the individual semiconductor circuits are positioned, are composed of one rotatable transfer assembly provided with at least two transfer heads, each transfer head structured for picking up a chip in the first position, and for positioning the chip in the at least second position through rotation of the at least one rotatable transfer assembly using a rotational motor about an axis of rotation. The at least two transfer heads are also driven by at least one rotational transfer head motor for manipulating the semiconductor circuit in each first and at least second position by means of in-and-out radial translational movement.

The use of at least two traditional rotational motors, operated separately from each other, for separately rotating the rotatably driven transfer assembly and the rotatably driven transfer heads has some significant structural and operational drawbacks. A drawback is machine speed loss, due to rotatably driven transfer heads being connected to the same rotational transfer head motor, thus requiring their semiconductor circuit manipulations being performed in time-sequential order, instead of parallel.

Another drawback pertain to quality issues. Due to hardware dimensional tolerances, semiconductor circuit may not be positioned on the correct, intended location (e.g. out of focus of inspection cameras). Quality issues can occur also, due to the relative high impact mass, when more transfer heads are connected to the same rotational transfer head motor, which potentially may cause chip damage. Quality issues can also occur due to friction occurring from the rotation bearings from the rotational motors used, hampering the position control of the transfer heads manipulations. As a solution, each transfer heads could be connected to an individual rotational transfer head motor in order to individual transfer head manipulation control, however this is not possible due to volume constraints of the overall apparatus construction.

Another drawback is possible machine uptime loss, due to significant conversion time, when adapting the chip transferring apparatus from one configuration to another. The chip transferring apparatus has many configurations (e.g. different number of transfer heads, different positions for collecting, inspecting and placing the semiconductor circuit at several, different positions, etc. Furthermore, due to the volume consuming constructions for supporting the rotational motors, servicing such chip transferring apparatus has become burdensome.

Transfer module leading to chip pick and place placement inaccuracies and quality issues. These mechanical inaccuracies arise because each degree of freedom (rotation and radial translation from inside to outside and vice versa) has its own bearing (in our current design 3x rotational lower) and because there are fewer actuators than transfer heads, allowing independent compensation per transfer head via the servo motor is not possible.

Accordingly, it is a goal of the present disclosure to provide an improved apparatus for transferring chips having reduced constructional dimensions incorporating a simpler operating and driving mechanism, allowing the manipulation of semiconductor circuit at higher operating speeds, improved manipulation quality due to reduced impact mass and reduced friction.

The following document is mentioned as being a pertinent prior art illustration:
US 2019/122917 A1 discloses a chip transfer device for transferring chips from a wafer to a placement head of an automatic placement machine.

The following documents are also mentioned as being an additional prior art illustration:
WO 03/058708 A1
US 2014/212246 A1

### SUMMARY OF THE DISCLOSURE

According to a first example of the disclosure, an apparatus for transferring chips from a first position to at least a second position is proposed, the apparatus comprising at least one rotatable transfer assembly comprising at least two transfer heads, each transfer head structured for picking up a chip in the first position, and for positioning the chip in the at least second position through rotation of the at least one rotatable transfer assembly about an axis of rotation; a transfer assembly actuator for driving the rotatable transfer assembly together with the at least two transfer heads about the axis of rotation; as well as at least a first transfer head actuator structured for actuating at least one transfer head in a radial direction relative to the axis of rotation, the at least first transfer head actuator being mounted to the rotatable transfer assembly actuator and comprising an actuator element coupled to the at least one transfer head, the actuator element structured to be actuated in the direction of the axis of rotation relative to the rotatable transfer assembly actuator.

The actuator element structured to be actuated in the direction of the axis of rotation relative to the rotatable transfer assembly actuator solves the problem of mechanical inaccuracies in the known applications. The complete construction is capable of rotating around the axis of rotation requiring only one rotational motor or actuator, resulting in a simpler construction with a reduced number of moving parts, such as bearings. Overall, this results in an apparatus of limited volumetric dimensions with an improved accuracy as to the manipulation of the individual semiconductor circuits, and limited machine uptime loss and servicing time. With this simplified mechanical construction, each transfer head can be actuated by its own transfer head actuator improving operational flexibility and accuracy per transfer head as this configuration allows accuracy corrections per transfer head / semiconductor circuit. Alternatively, two (or more) transfer heads can be actuated by one transfer head actuator allowing parallel manipulations of semiconductor chips.

In a preferred example, the actuator element is coupled to the at least one transfer head by means of a bar-linkage or cable-linkage mechanism.

Preferable, the at least first transfer head actuator comprises an actuator component mounted to the rotatable transfer assembly actuator, and the actuator element structured to be actuated in the direction of the axis of rotation relative to the actuator component. Herewith, the complete transfer head actuator rotates together with the transfer assembly actuator with a separate component structured to actuate the one or more transfer heads for semiconductor circuit manipulation.

In a preferred example, the at least first transfer head actuator comprises a magnet-coil drive unit for actuating the actuator element in the direction of the axis of rotation relative to the rotatable transfer assembly actuator. Such contact less actuating principle ensures proper mechanical accuracy and instantaneous response times, further increasing overall machine speed.

In particular, in order to further increase instantaneous response times and machine speed, the magnet-coil drive comprises multiple magnet elements mounted to the actuator element surrounding a coil element being mounted to the actuator component. In an alternative embodiment the multiple magnet elements are mounted to the actuator component, whilst the coil element is mounted to the actuator element.

In an example, the at least first transfer head actuator comprises a guiding element interconnecting the actuator element and the actuator component, wherein the guiding element is chosen from the group not limited consisting of a membrane element, a spring element, a ball bearing, an air bearing, etc. Again, such construction improves mechanical accuracy and instantaneous response times, further increasing overall machine speed.

In a further example according to the disclosure, the at least first transfer head actuator further comprises at least one sensing device for sensing a displacement of the actuator element in the direction of the axis of rotation relative to the rotatable transfer assembly actuator. Such sensing allows for an accurate actuating of the corresponding transfer head in the radial direction relative to the axis of rotation thus improving the accuracy of the semiconductor circuit manipulation. As the sensing device is mounted to the transfer head actuator, which in turn is mounted to the rotatable transfer assembly actuator, the displacement change is sensed in the direction of the axis of rotation irrespective of the rotation (direction and/or speed) of the overall construction.

In a example, the sensing device can be embodied as a linear encoder sensing an encoding scale placed on the actuator element, which encoding scale encodes a position along the axis of rotation. The linear encoder is structured to scan the encoding scale in order to convert the encoded position into an analog or digital signal. In order to ensure machine speed and efficient readout, the sensing device is mounted to the actuator component whereas the encoding scale is placed on the actuator element, which is displaced relative to the actuator component in the direction along the axis of rotation.

Due to the simpler, and less volumetric construction of the apparatus according to the disclosure, the number of transfer heads can be increased for example to four, six, eight, sixteen, or even more transfer heads. Accordingly, the construction of the apparatus can be expanded in only the direction of the axis of rotation by mounting a further transfer head actuator to the at least first transfer head actuator seen in the direction of the axis of rotation.

It should be noted, that the improved construction of the apparatus according to the disclosure - having less volumetric dimensions, less mechanical inaccuracies, and less friction between its moving parts - allows for each transfer head being actuated by its own transfer head actuator. On other hand, each transfer head actuator can be structured to actuate two or more transfer heads, depending on the implementation of the chip transfer apparatus.

In an example, the apparatus further implements a wafer-positioning device structured to position a wafer with chips surfaces thereof extending in a first plane in the first position, as well as a lead frame positioning device for positioning a lead frame, or antenna-foils or packaging tapes etc. with a bond surface thereof extending in a second plane at the second position.

In an additional implementation, the apparatus according to the disclosure may comprise a chip surface inspection device extending in a third plane in a third position. For example, said third position can be an intermediate position between the first and second position, seen in the direction of rotation of the rotatable transfer assembly, allowing for visual inspection in the intermediate, third position of a semiconductor circuit picked up by a transfer head in the first position, prior to the placement of the inspected semiconductor circuit by the transfer head in the second position.

In addition, the apparatus according to the disclosure may comprise a chip transfer device extending in a fourth plane in a fourth position, for example for transferring semiconductor circuits to a further processing line.

### BRIEF DESCRIPTION OF THE DRAWINGS

The disclosure will now be discussed with reference to the drawings, which show in:
Figure 1 a schematic depiction of an apparatus for transferring semiconductor circuits according to the state of the art;
Figure 2 a schematic depiction of an apparatus for transferring semiconductor circuits according to the disclosure;
Figures 3-5 further examples of apparatuses for transferring semiconductor circuits according to the disclosure;
Figures 6-8 detailed views of an example of a transfer head actuator according to the disclosure for implementation in an apparatus according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

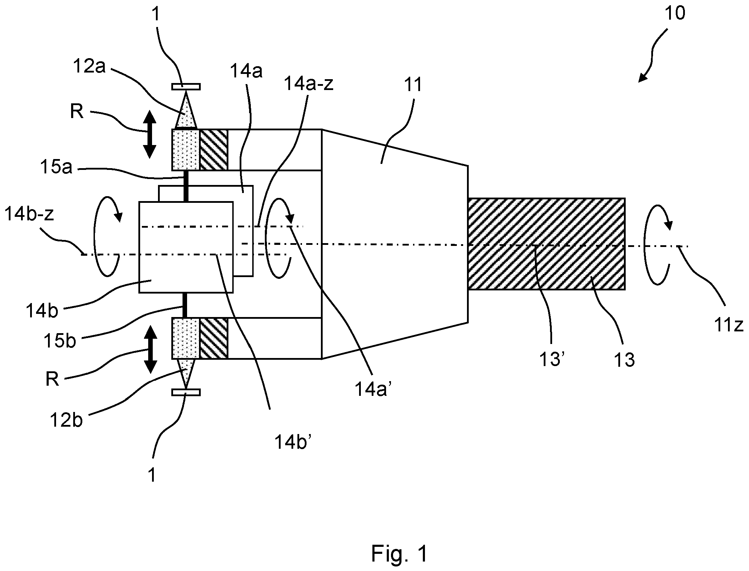

Figure 1 depict a schematic example of an apparatus for transferring semiconductor circuits from a first position to at least a second position according to the state of the art.

As outlined in the introduction, semiconductor circuits are manufactured on and in a circular plane substrate, also referred to as a wafer, in a matrix having a plurality of rows and columns of such circuits. For separating the plurality of individual semiconductor circuits (hereinafter also to be referred to as "chips" or "dies") from the wafer and arrange them individually on e.g. a carrier film for further handling and transportation, Figure 1 depicts a schematic, yet known example of an apparatus for transferring chips from a first position, e.g. in which position the wafer with the matrix of semiconductor circuits is positioned, to at least a second position, e.g. in which position a carrier film with the individual semiconductor circuits are positioned.

The apparatus for transferring chips according to the state of the art is denoted with reference numeral 10. Throughout this specification, the individual semiconductor circuits or chips are denoted with reference numeral 1.

The apparatus 10 is composed of a transfer assembly 11 which is rotatable driven by means of a rotational motor or transfer assembly actuator 13. The transfer assembly actuator 13 is provided with one or more transfer assembly actuator bearings 13' and is capable for rotating the transfer assembly 10 around an axis of rotation, which axis of rotation is denoted with reference numeral 11z in Figure 1.

To the transfer assembly 11 are mounted preferably at least two transfer heads 12 (denoted with 12a-12b). Although the apparatus 10 can operate with one transfer head 12 mounted to the rotatable transfer assembly 11, it is preferred - for machine speed considerations - to have at least two transfer heads 12a-12b mounted to the transfer assembly 11. Each transfer head 12; 12a-12b is structured for picking up a semiconductor circuit or chip 1 in the first position, and for positioning the chip 1 in the at least second position through rotation of the rotatable transfer assembly 11 by means of the transfer assembly actuator 13 around the axis of rotation 11z.

Furthermore, as shown in Figure 1, for a proper manipulation of the semiconductor circuit (chip) 1 in each first and second position, e.g. for picking the chip 1 up from a wafer positioned in the first position and for placing the chip 1 on a carrier film in the second position, each transfer head 12a-12b are likewise driven by a corresponding rotational transfer head motor 14 (14a-14b). Each rotational transfer head motor 14a and 14b is provided with a transfer head actuator bearing 14a'-14b' allowing rotation around their individual axis of rotation 14a-z and 14b-z respectively. The axis of rotations 11z, 14a-z and 14b-z are not in a perfect concentric orientation with each other, thus creating mechanical accuracies for the transfer heads 12a-12b. In addition, each rotational transfer head motor 14a and 14b is provided with a connecting mechanism 15a and 15b actuating the transfer head 12a-12b in order to pick up a semiconductor circuit or chip 1 in the first position, and to position or place the chip 1 in the second position.

In this known configuration, rotational motors 14a-14b are implemented for each transfer head 12a-12b. However, in a more common configuration, two or even four rotatably driven transfer heads 12 can be connected to the same rotational transfer head actuator 14. Such configuration has some significant structural and operational drawbacks. A main drawback is machine speed loss, when rotatably driven transfer heads being connected to the same rotational transfer head motor, requiring their semiconductor circuit manipulations being performed in time-sequential order, instead of parallel.

Another drawback pertain to quality issues due to friction occurring from the rotation bearings 13', 14a' and 14b' from the rotational actuators or motors used, hampering the position control of the transfer heads manipulations. As a solution, each transfer head 12 could be connected to an individual rotational transfer head actuator (motor) 14 in order to individual transfer head manipulation control, however this is not possible due to volume constraints of the overall apparatus construction.

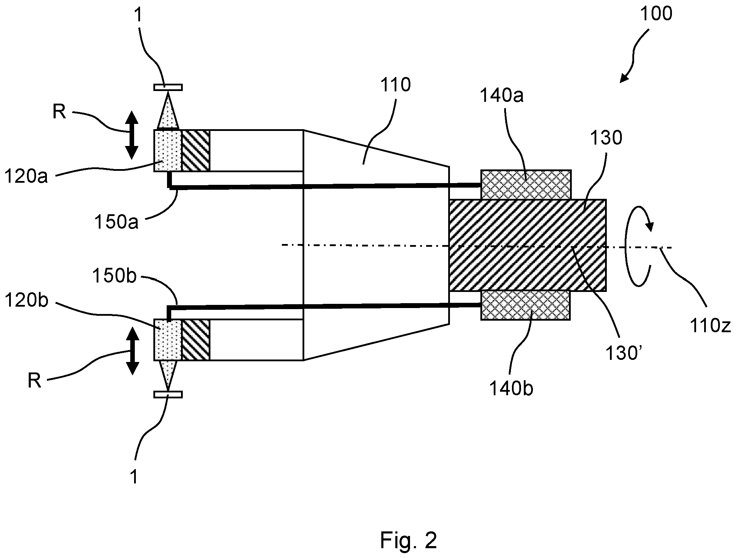

Figure 2 shows a schematic depiction of a first example of the disclosure, wherein the apparatus for transferring semiconductor circuits or chips 1 from a first position to at least a second position is denoted with reference numeral 100. The apparatus 100 comprises at least one rotatable transfer assembly 110. To the rotatable transfer assembly 110 at least two transfer heads 120 (120a-120b) are mounted. Similarly, each transfer head 120 (120a-120b) serves for picking up a chip 1 in the first position, and for positioning the chip 1 in the at least second position through radial displacement relative to the axis of rotation of 110z the rotatable transfer assembly 110. Rotation of the at least one rotatable transfer assembly 110 about its axis of rotation 110z ensures that each transfer head 120 (120a-120b) is displaced, through rotation, from the first position towards the at least second position.

Rotation of the transfer assembly 110 about its axis of rotation 110z is achieved with a transfer assembly actuator 130. According to the disclosure, the transfer assembly actuator 130 drives or rotates the rotatable transfer assembly 110 together with the at least two transfer heads 120 (120a-120b) about one, single axis of rotation 110z. As the complete construction of the apparatus 100 according to the disclosure and as depicted in Figure 2 is capable of rotating around one axis of rotation 110z with the use of only one rotational motor or actuator 130, a simpler construction is obtained with a significantly reduced number of moving parts, such as only one bearing 130'. Also, mechanical inaccuracies due to eccentric rotational axes as in the known device shown in Figure 1 are absent. Overall, this results in an apparatus 100 of limited volumetric dimensions with an improved accuracy as to the manipulation of the individual semiconductor circuits, and limited machine uptime loss and servicing time.

Furthermore, at least a first transfer head actuator 140 (140a) is used to actuate at least one corresponding transfer head 120 (120a) in a radial direction relative to the axis of rotation 110z, as depicted by the arrows R in Figure 2. In this example, two transfer head actuators 140a-140b are used to actuate corresponding transfer heads 120a-120b, each with the assistance of a connecting mechanism 150a-150b, such as a bar-linkage mechanism or a cable mechanism. As shown, the transfer head actuators 140 (140a-140b) are mounted to the rotatable transfer assembly actuator 130.

Accordingly, the complete configuration of the apparatus 100 according to the disclosure consisting of the transfer assembly 110, the several transfer heads 120, the transfer assembly actuator 130 and the transfer head actuators 140 are mounted on one single bearing 130' and being capable of rotating entirely about the single axis of rotation 110z. The advantages of such simpler construction are clear. Next to a significantly reduced number of moving parts, also the volumetric dimension of such configuration are limited, and next to an increase of machine speed, chips 1 can be manipulated faster and at higher accuracies. Also its simpler construction reduces machine uptime loss and servicing time.

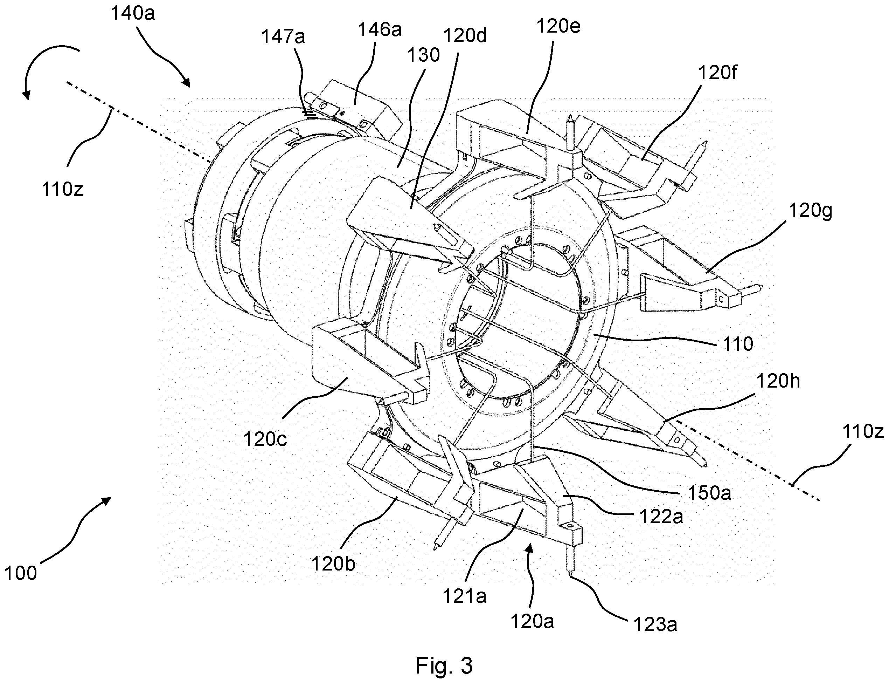

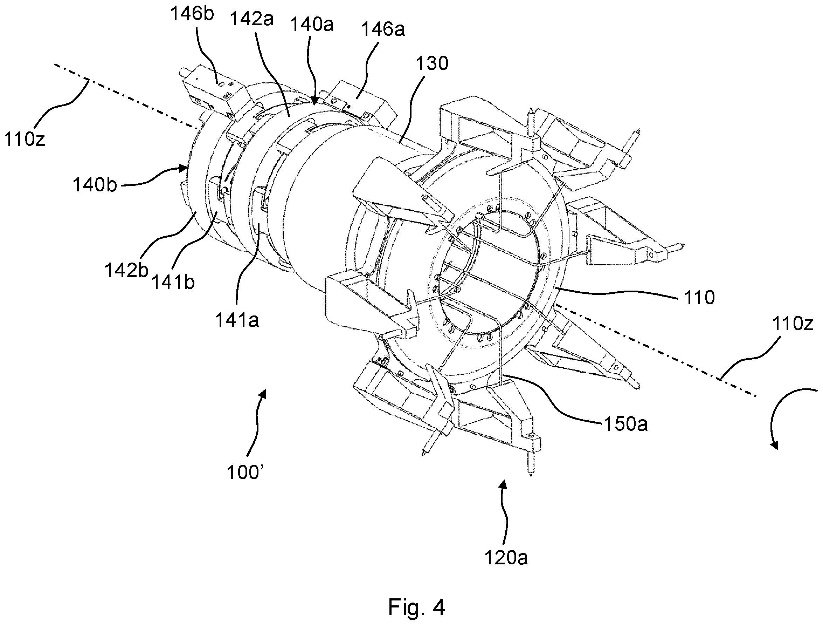

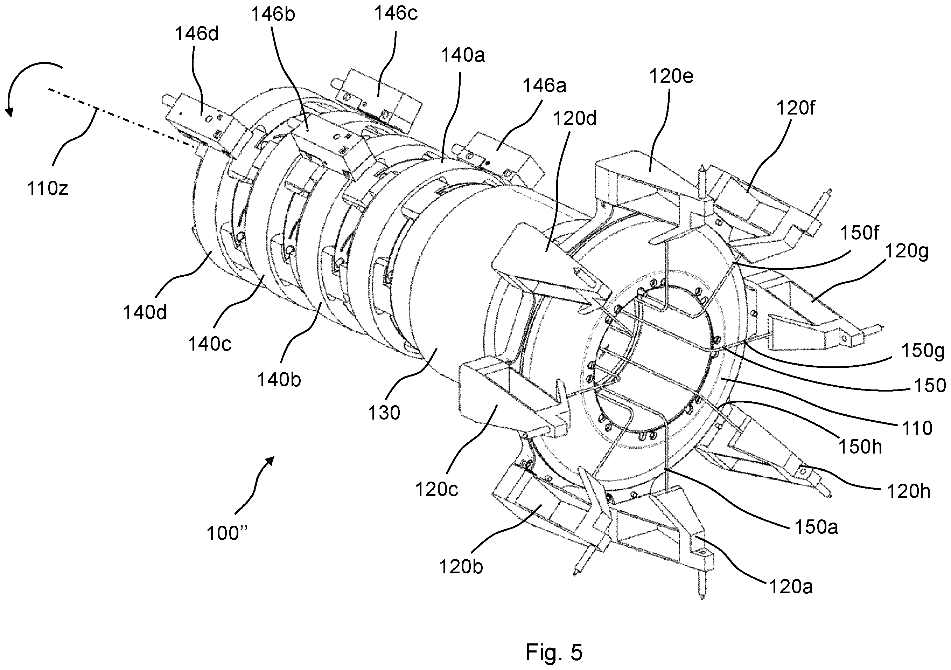

Figures 3-5 depict in more details examples of an apparatus according to the disclosure, denoted with reference numerals 100 (Figure 3), 100' (Figure 4) and 100" (Figure 5). In Figure 3 chip transfer apparatus 100 according to the disclosure is composed of the transfer assembly 110, the transfer assembly actuator 130, several, here eight, transfer heads 120a-120h, and one transfer head actuator 140a. Note, that the number of transfer heads 120 is arbitrary and depends on the type of application of the apparatus 100. Accordingly, one, two, four, eight, even sixteen transfer heads 120 (in such case indicated with reference numerals 120a-120p) can be mounted to the rotatably transfer assembly 110.

In this example, each transfer head 120a-120h is composed of a transfer head body 121a-121h mounted to the transfer assembly 110, and a transfer head arm 122a-122h, which is movable or hinged connected with the transfer head body 121a-121h. Each transfer head arm 122a-122h carries a pick-up element 123a-123h capable to interact with a chip 1 in a known matter. For the sake of simplicity, in Figure 3 only the reference numerals 121a-122a-123a of the associate transfer head 120a are shown, it is clear that in the configuration of eight transfer heads 120, the other seven transfer heads 120b-120h likewise comprise corresponding parts 121x-122x-123x (with x representing the relevant suffix letter b till h).

The transfer head arm 122a-122h is connected through a corresponding cable mechanism 150a-150h with the transfer head actuator 140a. Actuation of the cable mechanism 150a-150h (which will be discussed in detail later in this description) allows the transfer head arm 122a-122h to displace relative to the corresponding transfer head body 121a-121h, moving the pick-up element 123a-123h in a radial direction relative to the axis of rotation 110z, e.g. away from and towards the axis 110z, as shown with the arrows R in Figure 2. The radial movement of the pick-up element 123a-123h allows for picking a chip 1 up from a wafer positioned in the first position and for placing the chip 1 on a carrier film in the second position.

Although all transfer heads 120a-120h can be linked with one and the same transfer head actuator 140a, e.g. as depicted in Figure 3, further transfer head actuators 140b, 140c, 140d, etc. can be implemented. For example, as shown in Figure 4, as the overall construction of the chip transfer apparatus 100' according to the disclosure rotates around one single axis of rotation 110z, at least one further transfer head actuator 140b can be mounted to the first transfer head actuator 140a seen in the direction of the axis of rotation 110z. This allows for the advantageous upscale of the apparatus of the disclosure along its axis of rotation 110z also in terms of machine speed, by expanding the apparatus with additional transfer head actuators 140(a-d) for actuating one or more additional transfer heads 120a-120h mounted to the rotatable transfer assembly 110.

Such example is shown in Figure 5, depicting a chip transfer apparatus 100" according to the disclosure, which rotates around one single axis of rotation 110z, and is provided with four transfer head actuators 140a-140b-140c-140d, each mounted to a previous transfer head actuator seen in the direction of the axis of rotation 110z. The complete arrangement of multiple transfer head actuators is mounted to the rotatable transfer assembly 110.

As clearly shown in Figures 3-5, the several examples of an apparatus 100-100'-100" according to the disclosure exhibit limited volumetric dimensions as only the elongated constructional dimension of the apparatus, seen in the direction of the axis of rotation, changes with the number of transfer head actuators 140 mounted to the rotatable transfer assembly 110. Accordingly, this design configuration has less mechanical inaccuracies, and less friction between its moving parts as the overall construction rotates about one single axis of rotation 110z, requiring on single bearing 130' (Figure 2).

This principle of adding additional transfer head actuators 140 along the axis of rotation 110z allows for each transfer head 120 to be actuated by its own transfer head actuator 140. On other hand, each transfer head actuator 140 can be structured to actuate two or more transfer heads 120, depending on the implementation of the chip transfer apparatus 100-100'-100". For example, in Figure 3, the eight transfer heads 120a-120h can be actuated together and simultaneously by the single transfer head actuator 140a, whereas in the apparatus 100' of Figure 4, the eight transfer heads 120a-120h can be grouped in two separate sets of four transfer heads each, e.g. one set consisting of transfer heads 120a, 120c, 120e and 120g and the other set consisting of transfer heads 120b, 120d, 120f and 120h, each set being actuated together and simultaneously by one of the two transfer head actuators 140a and 140b. Likewise, in the apparatus 100" of Figure 5, the eight transfer heads 120a-120h can be grouped in four separate sets of two transfer heads each, e.g. one set consisting of transfer heads 120a and 120e, a second set consisting of transfer heads 120b and 120f, a third set consisting of transfer heads 120c and 120g, and the fourth set consisting of transfer heads 120d and 120h. Similarly, each set is being actuated together and simultaneously by one of the four transfer head actuators 140a-140d, all actuation/manipulation taking placing through the respective cable mechanisms 150a-150h.

As each transfer head 120 can be actuated by its own transfer head actuator 140 operational flexibility and accuracy per transfer head can be significantly improved, as such 1-on-1 configuration allows accuracy corrections per transfer head 120 / semiconductor circuit 1. Alternatively, two (or more) transfer heads can be actuated by one transfer head actuator allowing parallel manipulations of semiconductor chips.

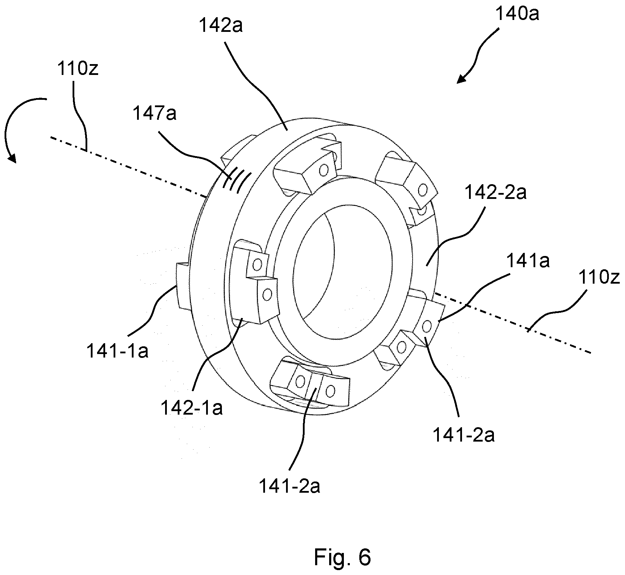

Figures 6-8 show in more detail the functionality of a transfer head actuator 140. In the Figures 6-8 the transfer head actuator is denoted with reference numeral 140a. However, if more than one transfer head actuator 140 is used as depicted for example in Figures 4 and 5, subsequent letter suffixes are applied for the first and any further transfer head actuator 140. Accordingly, as stated above, in an example each transfer head 120x can be actuated by its own transfer head actuator 140x (with x representing the relevant suffix letter a till h or even more such as a till p). The transfer head actuator 140 (a-h) can have a more or less cylindrical configuration, having a reduced impact mass, and balanced inertia during rotation about the axis of rotation 110z. Each transfer head actuator 140 (ah) has an actuator element 142 (a-h), which is coupled to at least one transfer head 120 (ah) through a corresponding connecting mechanism 150 (a-h). The actuator element 142 (ah) is structured to be actuated in the direction of the axis of rotation 110z relative to the rotatable transfer assembly actuator 130. With the movement of the actuated actuator element 142 (a-h) in the direction of the axis of rotation 110z relative to the rotatable transfer assembly actuator 130 the problem of mechanical inaccuracies in the known applications is solved.

In particular, the use of a connecting mechanism 150 (a-h), such as a bar-linkage mechanism or a cable mechanism, interconnecting the actuator element 142 (a-h) with at least one transfer head 120 (a-h) provides a sturdy and reliable actuation mechanism due to the absence of any friction and mechanical play. This actuation mechanism thus improves the mechanical accuracy of the manipulation of the semiconductor circuits 1.

As further shown in Figure 6, reference numeral 141 (a-h) denotes an actuator component as a further part of the associated transfer head actuator 140 (a-h). The actuator component 141 (a-h) is fixedly mounted to the rotatable transfer assembly actuator 130. In a non-limiting example, the actuator component 141 (a-h) can be formed as a ring shaped base element 141-1 (a-h) provided with several extension parts 141-2 (ah) evenly distributed along the circumference of ring shaped base element 141-1 (a-h) and extending in the direction of the axis of rotation 110z. The extension parts 141-2 (a-h) are to be mounted in a fixed manner to the rotatable transfer assembly actuator 130.

The actuator element 142 (a-h) is also structured as a ring shaped element having several openings 142-1 (a-h) also evenly distributed along its circumference. Each extension parts 141-2 (a-h) is accommodated in a corresponding openings 142-1 (a-h), allowing a contactless movement of the actuator element 142 (a-h) in the direction of the axis of rotation 110z relative to the actuator component 141 (a-h).

Similarly, when looking at Figures 4 and 5 showing multiple transfer head actuators 140a-140d mounted in line with each other along the axis of rotation 110z, the actuator component 141b-141d of at least one further transfer head actuator 140b-140d is mounted to the actuator component 141a-141c of the previous transfer head actuator 140a-140c thus creating one rigid construction further increasing mechanical accuracy with limited moving parts, hence reduced friction.

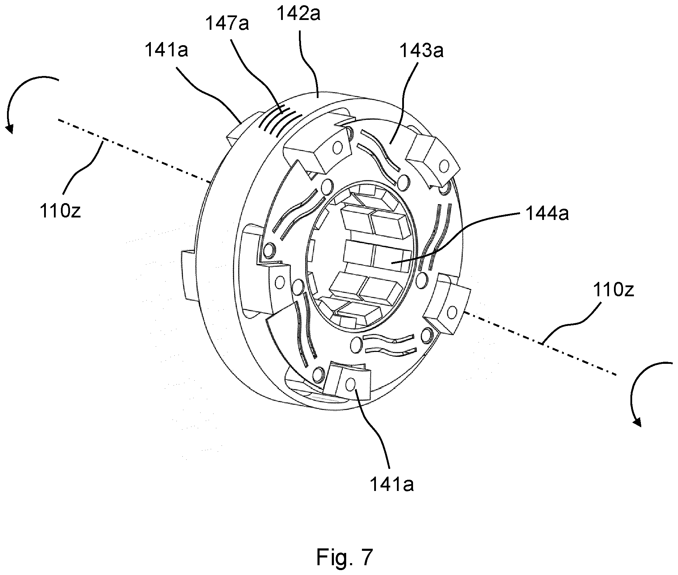

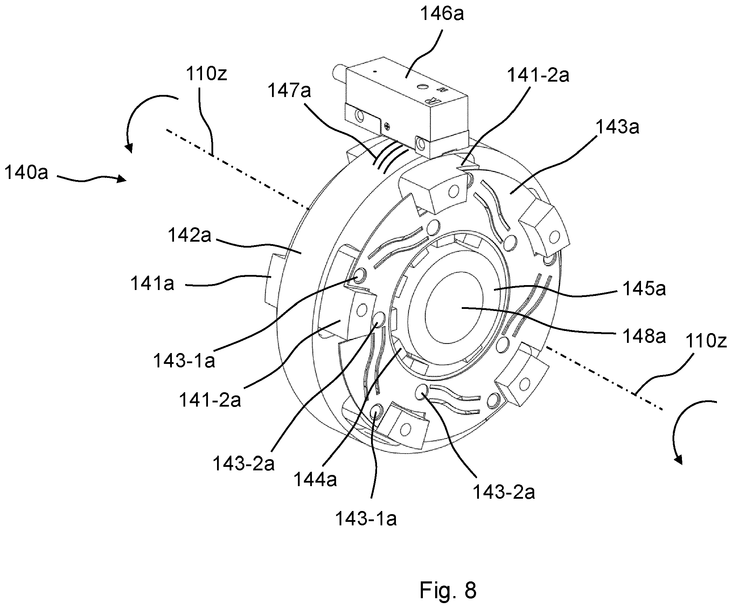

In an example shown in Figures 7 and 8, each transfer head actuator 140 (a-h) comprises a magnet-coil drive unit 148 (a-h) for actuating the actuator element 142 (a-h) in the direction of the axis of rotation 110z relative to the rotatable transfer assembly actuator 130 (and the actuator component 141 (a-h)). Such contact less actuating principle ensures proper mechanical accuracy and instantaneous response times, further increasing overall machine speed.

In particular, in order to further increase instantaneous response times and machine speed, the magnet-coil drive 148 (a-h) comprises multiple magnet elements 144 (a-h) mounted at the inner circumference of the ring shaped actuator element 142 (a-h) surrounding a coil element 145 (a-h) being mounted to the actuator component 141 (a-h). In an alternative embodiment the multiple magnet elements 144 (a-h) are mounted to the actuator component 141 (a-h), whereas the coil element 145 (a-h) is mounted to the actuator element 142 (a-h).

To ascertain mechanical accuracy and instantaneous response times, when displacing the actuator element 142 (a-h) relative to the actuator component 141 (a-h) in the direction of the axis of rotation 110z, each transfer head actuator 140 (a-h) comprises a guiding element 143 (a-h) interconnecting the actuator element 142 (a-h) and the actuator component 141 (a-h). The guiding element 143 (a-h) can be chosen from the group not limited consisting of a membrane element, a spring element, a ball bearing, an air bearing, etc. In the depicted example of Figure 8, the guiding element 141 (a-h) is formed as a disc shaped spring element having first mounting points 143-1 (a-h) for mounting / interconnecting with an extension part 141-2 (a-h) of the actuator component 141 (a-h) and second mounting points 143-2 (a-h) for mounting / interconnecting with the actuator element 142 (a-h). Such construction allows frictionless movements of the several parts without any mechanical play, thus ensuring operational reliability and accuracy..

Accordingly, with the actuator component 141 (a-h) being mounted to the transfer assembly actuator 130, the complete transfer head actuator 140 (a-h) rotates together with the transfer assembly actuator 130 (and the rotatable transfer assembly 110 with the several transfer heads 120) about the axis of rotation 110z, whereas the separate actuator component 141 (a-h) can be displaced - upon actuation of the magnet-coil drive 148 combined with the guiding element 143 (a-h) - in the direction of the axis of rotation 110z relative to the rotatable transfer assembly actuator 130 (and the rotatable transfer assembly 110 with the several transfer heads 120), in order to actuate via the associated cable mechanism 150 (a-h) the one or more transfer heads 120 (a-h) for semiconductor circuit manipulation.

Upon actuation of the magnet-coil drive 148 (a-h) the actuator element 142 (a-h) is displaced in the direction of the axis of rotation 110z relative to the actuator component 141, due to the electromagnetic forces generated. The actuator element 142 (a-h) is fixedly connected with one end of a corresponding cable mechanism 150 (a-h), whereas the other end of the cable mechanism 150 (a-h) is fixedly connected with a corresponding transfer head 120 (a-h), in particular with the corresponding transfer head arm 122a-122h. The displacement (back and forth along the axis of rotation) of the actuator element 142 (a-h) is transferred via the cable mechanism 150 (a-h) towards the transfer head arm 122 (a-h) and the associated pick-up element 123 (a-h) can be displaced in a radial direction relative to the axis of rotation 110z, as depicted by the arrows R in Figure 2, for performing the respective picking up and placing of a chip 1.

In the Figures 3-5 and 8, reference numeral 146 (a-d) denotes a sensing device for sensing a displacement of the actuator element 142 (a-h) in the direction of the axis of rotation 110z relative to the actuator component 141 (a-h) / the rotatable transfer assembly actuator 130 / the rotatable transfer assembly 110 / the transfer heads 120 (a-h). Such sensing allows for an accurate actuating of the corresponding transfer head 120 in the radial direction relative to the axis of rotation 110z thus improving the accuracy of the semiconductor circuit manipulation. As the sensing device 146 (a-h) is mounted to the transfer head actuator 140 (a-h), which in turn is mounted to the rotatable transfer assembly actuator 130, the displacement change is sensed in the direction of the axis of rotation 110z irrespective of the rotation (direction and/or speed) of the overall construction 100-100'-100".

For redundancy purposes, further improving mechanical accuracy, each transfer head 120 (a-h) can be provided with more than one sensing devices 146 (a-h).

In an example, the sensing device 146 can be embodied as a linear encoder sensing an encoding scale 147 (a-h) placed on a surface, e.g. the outer circumference of the disc-shaped actuator element 142 (a-h), which encoding scale encodes a position along the axis of rotation 110z. The linear encoder 146 is structured to scan the encoding scale 147 in order to convert the encoded position into an analog or digital signal.

### LIST OF REFERENCE NUMERALS

- 1: semiconductor circuit or chip

### STATE OF THE ART

- 10: apparatus for transferring chips
- 11: rotatable transfer assembly
- 11z: axis of rotation of transfer assembly
- 12a-12b: transfer heads
- 13: transfer assembly actuator
- 13': transfer assembly actuator bearing
- 14a-14b: rotatable transfer head actuator
- 14a'-14b': transfer head actuator bearing
- 14a-z: axis of rotation of transfer head actuator 14a
- 14b-z: axis of rotation of transfer head actuator 14b
- 15a-15b: connecting mechanism for transfer head 12a-12b

### DISCLOSURE

- 100-100'-100": apparatus for transferring chips (1^{st}-2^{nd}-3^{rd} embodiment)
- 110: rotatable transfer assembly
- 110z: axis of rotation of transfer assembly
- 120(a-h): transfer heads
- 121(a-h): transfer head body
- 122(a-h): transfer head arm
- 123(a-h): pick up element
- 130: transfer assembly actuator
- 130': transfer assembly actuator bearing
- 140(a-h): transfer head actuator for transfer head 120a-120h
- 141(a-h): actuator component
- 142(a-h): actuator element
- 143(a-h): guiding element, e.g. a spring element, ball bearing, air bearing
- 144(a-h): magnet elements
- 145(a-h): coil element
- 146(a-h): sensing device (linear encoder)
- 147(a-h): encoding scale
- 148(a-h): magnet-coil drive unit
- 150(a-h): connecting mechanism for transfer head 120a-120h

## Claims

1. An apparatus for transferring chips (100-100'-100") from a first position to at least a second position, the apparatus comprising:
at least one rotatable transfer assembly (110) comprising at least two transfer heads (120(a-h)), each transfer head structured for picking up a chip in the first position, and for positioning the chip in the at least second position through rotation of the at least one rotatable transfer assembly about an axis of rotation (110z);
a transfer assembly actuator (130) for driving the rotatable transfer assembly together with the at least two transfer heads about the axis of rotation; as well as
at least a first transfer head actuator (140(a-h)) structured for actuating at least one transfer head in a radial direction relative to the axis of rotation, the at least first transfer head actuator being mounted to the rotatable transfer assembly actuator and comprising an actuator element (142(a-h)) coupled to the at least one transfer head, the actuator element structured to be actuated in the direction of the axis of rotation relative to the rotatable transfer assembly actuator.

2. The apparatus according to claim 1, wherein the actuator element is coupled to the at least one transfer head by means of a connecting mechanism (150(a-h))

3. The apparatus according to claim 1 or 2, wherein the at least first transfer head actuator comprises an actuator component (141 (a-h)) mounted to the rotatable transfer assembly actuator, and the actuator element structured to be actuated in the direction of the axis of rotation relative to the actuator component.

4. The apparatus according to claim 3, wherein the at least first transfer head actuator comprises a magnet-coil drive unit (148(a-h)) for actuating the actuator element in the direction of the axis of rotation relative to the rotatable transfer assembly actuator.

5. The apparatus according to claim 4, wherein the magnet-coil drive comprises multiple magnet elements (144(a-h)) mounted to the actuator element surrounding a coil element (145(a-h)) being mounted to the actuator component.

6. The apparatus according to any one or more of the claims 3-5, wherein the at least first transfer head actuator comprises a guiding element (143(a-h)) interconnecting the actuator element and the actuator component.

7. The apparatus according to claim 6, wherein the guiding element is chosen from the group not limited consisting of a membrane element, a spring element, a ball bearing, an air bearing, etc.

8. The apparatus according to any one or more of the preceding claims, wherein the at least first transfer head actuator further comprises at least one sensing device (146(a-h)) for sensing a displacement of the actuator element in the direction of the axis of rotation relative to the rotatable transfer assembly actuator.

9. The apparatus according to any one or more of the preceding claims, wherein the number of transfer heads is four, six, eight, sixteen, or more.

10. The apparatus according to any one or more of the preceding claims, wherein the apparatus comprises at least one further transfer head actuator mounted to the at least first transfer head actuator seen in the direction of the axis of rotation.

11. The apparatus according to claim 10, wherein the actuator component of the at least one further transfer head actuator is mounted to the actuator component of the previous transfer head actuator.

12. The apparatus according to claim 10 or 11, wherein the number of transfer head actuators is equal to or half of or quarter of the number of transfer heads.

13. The apparatus according to any one of the preceding claims, wherein the rotatable transfer assembly is rotated in one direction.

14. The apparatus according to any one of the preceding claims, further comprising a wafer-positioning device structured to position a wafer with chips surfaces thereof extending in a first plane in the first position, and a lead frame positioning device for positioning a lead frame with a bond surface thereof extending in a second plane at the second position.

15. The apparatus according to claim 14, further comprising a chip surface inspection device extending in a third plane in a third position.

## Patentansprüche

1. Vorrichtung zum Transferieren von Chips (100-100'-100") von einer ersten Position zu mindestens einer zweiten Position, wobei die Vorrichtung Folgendes umfasst:
mindestens eine drehbare Transferanordnung (110), umfassend mindestens zwei Transferköpfe (120(a-h)), wobei die Transferköpfe jeweils zum Aufnehmen eines Chips in der ersten Position und zum Positionieren des Chips in der mindestens zweiten Position durch Drehung der mindestens einen drehbaren Transferanordnung um eine Drehachse (110z) aufgebaut sind;
einen Transferanordnungsaktor (130) zum Antreiben der drehbaren Transferanordnung zusammen mit den mindestens zwei Transferköpfen um die Drehachse; sowie mindestens einen ersten Transferkopfaktor (140(a-h)), der zum Betätigen mindestens eines Transferkopfs in einer Radialrichtung relativ zu der Drehachse aufgebaut ist, wobei der mindestens erste Transferkopfaktor an dem Aktor der drehbaren Transferanordnung angebracht ist und ein an den mindestens einen Transferkopf gekoppeltes Aktorelement (142(a-h)) umfasst, wobei das Aktorelement dazu aufgebaut ist, in der Richtung der Drehachse relativ zu dem Aktor der drehbaren Transferanordnung betätigt zu werden.

2. Vorrichtung nach Anspruch 1, wobei das Aktorelement mittels eines Verbindungsmechanismus (150(a-h)) an den mindestens einen Transferkopf gekoppelt ist.

3. Vorrichtung nach Anspruch 1 oder 2, wobei der mindestens erste Transferkopfaktor eine an dem Aktor der drehbaren Transferanordnung angebrachte Aktorkomponente (141(a-h)) umfasst und das Aktorelement dazu aufgebaut ist, in der Richtung der Drehachse relativ zu der Aktorkomponente betätigt zu werden.

4. Vorrichtung nach Anspruch 3, wobei der mindestens erste Transferkopfaktor eine Magnetspulenantriebseinheit (148(a-h)) zum Betätigen des Aktorelements in der Richtung der Drehachse relativ zu dem Aktor der drehbaren Transferanordnung umfasst.

5. Vorrichtung nach Anspruch 4, wobei der Magnetspulenantrieb mehrere an dem Aktorelement angebrachte Magnetelemente (144(a-h)) umfasst, die ein Spulenelement (145(a-h)) umgeben, das an der Aktorkomponente angebracht ist.

6. Vorrichtung nach einem oder mehreren der Ansprüche 3-5, wobei der mindestens erste Transferkopfaktor ein Führungselement (143(a-h)) umfasst, das das Aktorelement und die Aktorkomponente miteinander verbindet.

7. Vorrichtung nach Anspruch 6, wobei das Führungselement aus der nicht beschränkten Gruppe ausgewählt ist, die aus einem Membranelement, einem Federelement, einem Kugellager, einem Luftlager usw. besteht.

8. Vorrichtung nach einem oder mehreren der vorangehenden Ansprüche, wobei der mindestens erste Transferkopfaktor ferner mindestens eine Abfühlvorrichtung (146(a-h)) zum Abfühlen einer Verschiebung des Aktorelements in der Richtung der Drehachse relativ zu dem Aktor der drehbaren Transferanordnung umfasst.

9. Vorrichtung nach einem oder mehreren der vorangehenden Ansprüche, wobei die Anzahl von Transferköpfen vier, sechs, acht, sechzehn oder mehr beträgt.

10. Vorrichtung nach einem oder mehreren der vorangehenden Ansprüche, wobei die Vorrichtung mindestens einen weiteren Transferkopfaktor umfasst, der an dem in der Richtung der Drehachse gesehenen mindestens ersten Transferkopfaktor angebracht ist.

11. Vorrichtung nach Anspruch 10, wobei die Aktorkomponente des mindestens einen weiteren Transferkopfaktors an der Aktorkomponente des vorherigen Transferkopfaktors angebracht ist.

12. Vorrichtung nach Anspruch 10 oder 11, wobei die Anzahl von Transferkopfaktoren gleich der Anzahl von Transferköpfen ist oder eine Hälfte davon oder ein Viertel davon beträgt.

13. Vorrichtung nach einem der vorangehenden Ansprüche, wobei die drehbare Transferanordnung in einer Richtung gedreht wird.

14. Vorrichtung nach einem der vorangehenden Ansprüche, ferner umfassend eine Wafer-Positionierungseinrichtung, die dazu aufgebaut ist, einen Wafer mit sich in einer ersten Ebene in der ersten Position erstreckenden Chipoberflächen davon zu positionieren, und eine Leadframe-Positionierungseinrichtung zum Positionieren eines Leadframe mit einer sich in einer zweiten Ebene an der zweiten Position erstreckenden Bondoberfläche davon.

15. Vorrichtung nach Anspruch 14, ferner umfassend eine sich in einer dritten Ebene in einer dritten Position erstreckende Chipoberflächen-Inspektionseinrichtung.

## Revendications

1. Appareil permettant de transférer des puces (100-100'-100") d'une première position vers au moins une deuxième position, l'appareil comprenant :
au moins un ensemble de transfert rotatif (110) comprenant au moins deux têtes de transfert (120(a-h)), chaque tête de transfert étant conçue pour prélever une puce dans une première position, et pour positionner la puce dans la au moins une deuxième position par rotation du au moins un ensemble de transfert rotatif autour d'un axe de rotation (110z) ;
un actionneur d'ensemble de transfert (130) permettant d'entraîner l'ensemble de transfert rotatif conjointement avec les au moins deux têtes de transfert autour de l'axe de rotation ; ainsi qu'au moins un premier actionneur de tête de transfert (140(a-h)) conçu pour actionner au moins une tête de transfert dans une direction radiale par rapport à l'axe de rotation, le au moins premier actionneur de tête de transfert étant montés sur l'actionneur d'ensemble de transfert rotatif et comprenant un élément actionneur (142(a-h)) accouplé à la au moins une tête de transfert, l'élément actionneur étant conçu pour être actionné dans la direction de l'axe de rotation par rapport à l'actionneur d'ensemble de transfert rotatif.

2. Appareil selon la revendication 1, dans lequel l'élément actionneur est accouplé à la au moins une tête de transfert au moyen d'un mécanisme de raccordement (150(a-h)).

3. Appareil selon la revendication 1 ou 2, dans lequel le au moins premier actionneur de tête de transfert comprend un composant actionneur (141(a-h)) monté sur l'actionneur d'ensemble de transfert rotatif, et l'élément actionneur est conçu pour être actionné dans la direction de l'axe de rotation par rapport au composant actionneur.

4. Appareil selon la revendication 3, dans lequel le au moins premier actionneur de tête de transfert comprend une unité d'entraînement à aimant-bobine (148(a-h)) permettant d'actionner l'élément actionneur dans la direction de l'axe de rotation par rapport à l'actionneur d'ensemble de transfert rotatif.

5. Appareil selon la revendication 4, dans lequel l'entraînement à aimant-bobine comprend plusieurs éléments aimant (144(a-h)) montés sur l'élément actionneur entourant un élément bobine (145(a-h)) monté sur le composant actionneur.

6. Appareil selon l'une quelconque ou plusieurs des revendications 3 à 5, dans lequel le au moins premier actionneur de tête de transfert comprend un élément de guidage (143(ah)) interconnectant l'élément actionneur et le composant actionneur.

7. Appareil selon la revendication 6, dans lequel l'élément de guidage est choisi dans le groupe non limité consistant en un élément membrane, un élément ressort, un roulement à billes, un palier à air, etc.

8. Appareil selon l'une quelconque ou plusieurs des revendications précédentes, dans lequel le au moins premier actionneur de tête de transfert comprend au moins un dispositif de détection (146(a-h)) destiné à détecter un déplacement de l'élément actionneur dans la direction de l'axe de rotation par rapport à l'actionneur d'ensemble de transfert rotatif.

9. Appareil selon l'une quelconque ou plusieurs des revendications précédentes, dans lequel le nombre de têtes de transfert est quatre, six, huit, seize ou plus.

10. Appareil selon l'une quelconque ou plusieurs des revendications précédentes, dans lequel l'appareil comprend au moins un autre actionneur de tête de transfert monté sur le au moins premier actionneur de tête de transfert vu dans la direction de l'axe de rotation.

11. Appareil selon la revendication 10, dans lequel le composant actionneur du au moins un autre actionneur de tête de transfert est monté sur le composant actionneur de l'actionneur de tête de transfert précédent.

12. Appareil selon la revendication 10 ou 11, dans lequel le nombre d'actionneurs de tête de transfert est égal au nombre de têtes de transfert, ou à la moitié ou au quart de ce nombre.

13. Appareil selon l'une quelconque des revendications précédentes, dans lequel l'ensemble de transfert rotatif est tourné dans une direction.

14. Appareil selon l'une quelconque des revendications précédentes, comprenant en outre un dispositif de positionnement de tranche conçu pour positionner une tranche dont des surfaces de puce s'étendent dans un premier plan dans la première position, et un dispositif de positionnement de grille de connexion pour positionner une grille de connexion dont une surface de liaison s'étend dans un deuxième plan au niveau de la deuxième position.

15. Appareil selon la revendication 14, comprenant en outre un dispositif d'inspection de surface de puce s'étendant dans un troisième plan dans une troisième position.
